# EUROPEAN PATENT APPLICATION

(11) **EP 4 692 154 A1**
(43) Date of publication of application: **11.02.2026**
(21) Application number: 25190961.0
(22) Date of filing: 22.07.2025
(51) Int. Cl.: C08G 59/40, C08G 59/50, C08G 59/62, C08G 59/68, C09J 163/00, C08G 73/10

(54) **HEAT-CURABLE RESIN COMPOSITION AND USE THEREOF**

(30) Priority: 08.08.2024 JP 2024131802
(71) Applicant: Shin-Etsu Chemical Co., Ltd., Tokyo 100-0005 (JP)
(72) Inventor: TSUTSUMI, Yoshihiro, Annaka, 3790224 (JP); TSUURA, Atsushi, Tokyo, 1000005 (JP); KUDO, Shunsuke, Annaka, 3790224 (JP); IGUCHI, Hiroyuki, Annaka, 3790224 (JP); IWASAKI, Masayuki, Annaka, 3790224 (JP); KUDO, Yuki, Annaka, 3790224 (JP)
(74) Representative: Angerhausen, Christoph

(57) **Abstract**

Provided is a heat-curable resin composition that not only has a low dielectric tangent but also is excellent in adhesivity, and that particularly results in a cured product which exhibits an excellent desmear resistance. The heat-curable resin composition includes (A) an aromatic cyclic imide compound having a weight average molecular weight of 5,000 to 100,000, (B) an aliphatic cyclic imide compound having a weight average molecular weight of 100 to 2,000, (C) an epoxy resin having two or more epoxy groups in one molecule, (D) a curing agent for epoxy resin, (E) a curing catalyst, and (F) an inorganic filler, wherein the heat-curable resin composition contains the components (A) to (E) in a total amount of 5 to 99% by mass based on the overall composition.

## Description

### BACKGROUND OF THE INVENTION

### Field of the invention

The present invention relates to a heat-curable resin composition, a bonding film, a prepreg, a copper foil, a build-up film, and a printed-wiring board.

### Background art

In recent years, a next-generation communication system known as 5G (millimeterwave region of 26 to 80 GHz) has prevailed, and even a next-next-generation communication system called 6G is already under development. To realize a communication system with a higher speed, a larger capacity, and a lower latency than ever before, it requires materials for use in a high-frequency band of 3 to 80 GHz, and it is critical to reduce a transmission loss as a countermeasure for noise. The term "transmission loss" refers to the sum of a conductor loss and a dielectric loss; it is necessary for reducing the conductor loss to lower the roughness of the surface of a metal foil, particularly of a copper foil, used. Meanwhile, since the dielectric loss is proportionate to a product of a square root of a relative permittivity and a dielectric tangent, it is demanded that there be developed an insulating material with excellent dielectric properties (i.e. with a low relative permittivity and a low dielectric tangent). Particularly, it is for substrate purposes that such insulating material with particularly excellent dielectric properties is required. There are now increasingly employed a material known as reactive polyphenylene ether resin (PPE) in the case of a rigid substrate; and materials known as liquid crystal polymer (LCP) and modified polyimide (MPI) in the case of flexible printed-circuit board (FPC).

Further, in a method for manufacturing a substrate which is called as "semi-additive process (SAP)" or as "modified semi-additive process (M-SAP)", a heat-curable thermosetting film for forming an insulating layer, referred to as a build-up film (interlayer lamination material) or an adhesive film (bonding film) for enhancing the adhesion between the thermosetting film, a substrate, and a metal are utilized. They use epoxy resins as their materials and those using active ester curing agents are often used to improve their dielectric properties in recent years (See JP-A-2024-37078).

In this regard, reports have been made on heat-curable resin compositions for substrates which substantially use a dimer diamine frame-containing maleimide compound (hereafter referred to as specific maleimide compound) (See WO-A-2016/114287 and JP-A-2018-201024). As opposed to the properties of conventional maleimide resins, a specific maleimide compound has a low glass-transition temperature (Tg) and a high coefficient of thermal expansion (CTE). However, it has significantly excellent dielectric properties compared to conventional heat-curable resins and has a flexible property. It also has many advantages including an excellent adhesion force to metals or the like compared to epoxy resins and is a heat-curable resin, which enables multi (high)-layering; a wide range of researches and developments are conducted with regard to such specific maleimide compound.

New build-up films and bonding films are being developed to leverage the unique properties of specific maleimide compounds (See JP-A-2020-83898). The specific maleimide compounds are primarily used to reduce the dielectric tangent of cured products and improve adhesion to metals, especially copper. Notably, a specific maleimide compound is incorporated into existing epoxy resin compositions to enhance dielectric performance and adhesivity. It has also been found that specific maleimide compounds make it easier to remove smears and leave clean vias when removing smear (desmear) in the wet desmear process after via formation.

Meanwhile, further investigation into the specific maleimide compound has revealed additional challenges. The adhesivity of materials generally decreases as the surface roughness of copper foil decreases; however, the specific maleimide compound exhibits sufficiently strong adhesivity against such copper foil. Nevertheless, a copper foil whose surface roughness is excessively low causes the resin to overly melt in the desmear process. It has been found that this causes the etching liquid to further penetrate deep into the interface between the resin and the copper foil, causing the resin to be readily peeled off from the copper foil.

### SUMMARY OF THE INVENTION

It is therefore an object of the present invention to provide a heat-curable resin composition that has a low dielectric tangent and is excellent in adhesivity, and that particularly results in a cured product which exhibits an excellent desmear resistance (resistance against etching liquid). It is also an object of the present invention to provide a bonding film, a prepreg, a copper foil, a build-up film and a printed-wiring board that contain the above-mentioned composition.

The inventors of the present invention diligently conducted a series of studies to solve the above problems, and completed the invention by finding that the heat-curable resin composition as shown below can achieve the above objects.
<1> A heat-curable resin composition comprising the components (A) to (F) of:
   (A) an aromatic cyclic imide compound having a weight average molecular weight of 5,000 to 100,000;
   (B) an aliphatic cyclic imide compound having a weight average molecular weight of 100 to 2,000;
   (C) an epoxy resin having two or more epoxy groups in one molecule;
   (D) a curing agent for epoxy resin;
   (E) a curing catalyst; and
   (F) an inorganic filler,
   wherein the heat-curable resin composition comprises the components (A) to (E) in a total amount of 5 to 99% by mass based on the overall composition.
<2> The heat-curable resin composition according to <1>, wherein the aromatic cyclic imide compound (A) comprises at least one selected from aromatic cyclic imides represented in the following by formulae (1) and (2) defined as 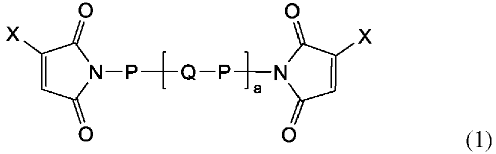
   wherein, in the formula (1), P and Q are independently divalent groups represented by formulae defined as
      **P:** 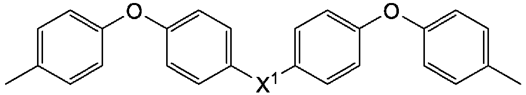
      **Q:** 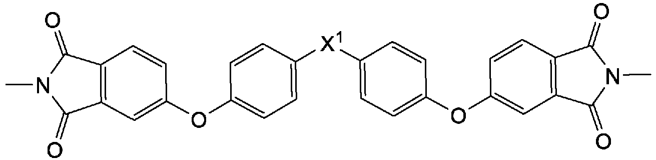 wherein each X¹ is independently a divalent group selected from formulae defined as 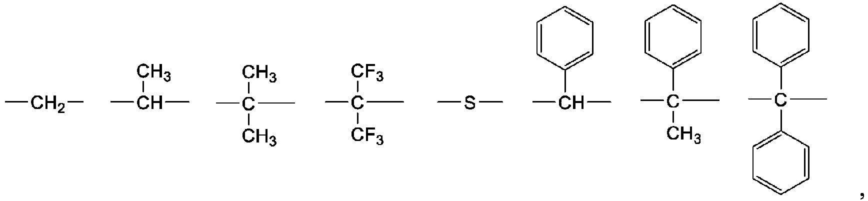 and
   wherein, in the formula (1), a is a number of 1 to 40 and each X represents a hydrogen atom or a methyl group; and 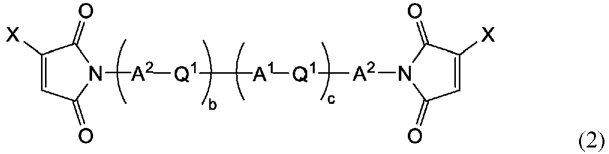
   wherein, in the formula (2), each Q¹ independently is a divalent group represented by a formula defined as
      **Q¹**: 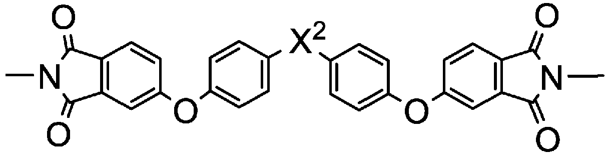 wherein each X² is independently a divalent group selected from formulae defined as 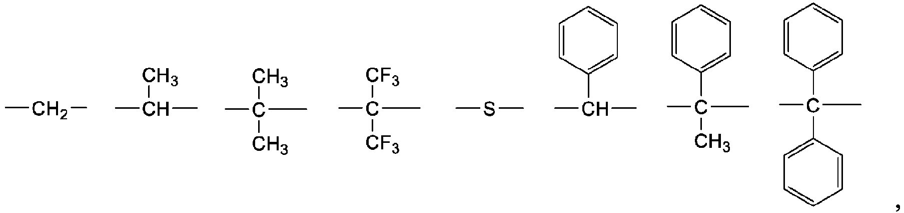 and
   wherein, in the formula (2), b is a number of 1 to 50, c is a number of 1 to 50, each X represents a hydrogen atom or a methyl group and each of A¹ and A² independently represents a divalent group selected from formulae (3) and (4) defined as 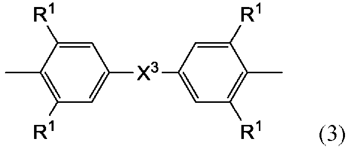 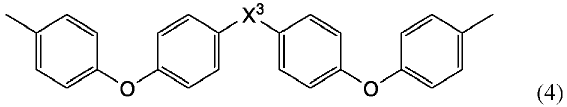
      wherein, in the formulae (3) and (4), each X³ is a divalent group selected from formula defined as 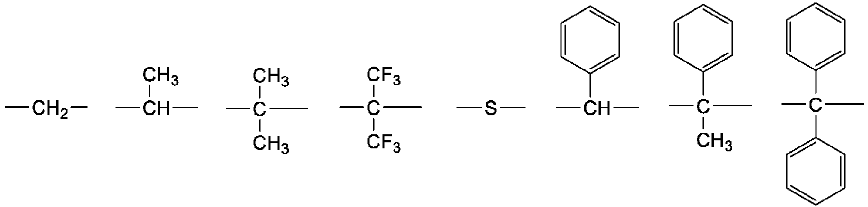
      wherein, in the formula (3), each R¹ independently represents a hydrogen atom, a chlorine atom, or an aliphatic hydrocarbon group having 1 to 6 carbon atoms.
<3> The heat-curable resin composition according to <1> or <2>, wherein the aliphatic cyclic imide compound (B) is an aliphatic cyclic imide compound represented by a formula (5) defined as 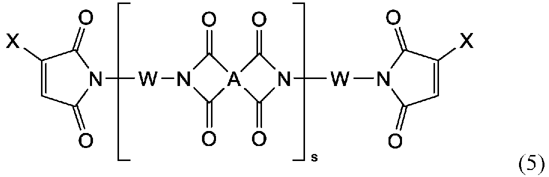 wherein, in the formula (5), each A independently represents a tetravalent organic group having an aliphatic cyclic structure, each X represents a hydrogen atom or a methyl group, each W independently represents a divalent aliphatic hydrocarbon group, having 5 to 25 caron atoms, which optionally contains a heteroatom, and s is 0 to 10.
<4> The heat-curable resin composition according to <3>, wherein W in the formula (5) is a linear or branched alkylene group having 5 to 25 carbon atoms or a divalent aliphatic hydrocarbon group represented by any one of the structures defined as 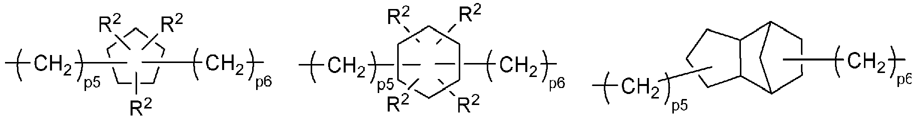 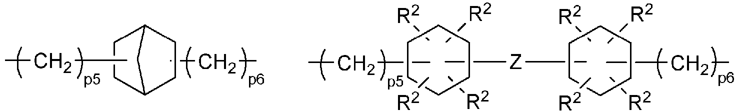 wherein p⁵ and p⁶ are each a number of 0 to 4 and may be identical to or different from each other, each R² independently represents a hydrogen atom or a linear or branched alkyl group having 1 to 20 carbon atoms, Z is an oxygen atom, a sulfur atom, or a methylene group, and wherein bonds in the above formulae that are yet unbonded to substituent groups are to be bonded to nitrogen atoms forming cyclic imide structures in the formula (5).
<5> The heat-curable resin composition according to any one of <1> to <4>, wherein the aliphatic cyclic imide compound (B) is contained therein in an amount of 5 to 150 parts by mass based on 100 parts by mass of the aromatic cyclic imide compound (A).
<6> The heat-curable resin composition according to any one of <1> to <5>, wherein the curing agent (D) for epoxy resin is an amine curing agent.
<7> A bonding film comprising the heat-curable resin composition according to any one of <1> to <6>.
8. A prepreg comprising a cured product of the heat-curable resin composition according to any one of <1> to <6>.
<9> A resin-clad copper foil comprising a cured product of the heat-curable resin composition according to any one of <1> to <6>.
<10> A build-up film comprising the heat-curable resin composition according to any one of <1> to <6>.
<11> A printed-wiring board comprising any one of the bonding film according to <7>, the prepreg according to <8>, the resin-clad copper foil according to <9>, and the build-up film according to <10>.

The heat-curable resin composition of the present invention not only has a low dielectric tangent but also is excellent in adhesivity, and particularly it provides a cured product which exhibits an excellent desmear resistance (resistance against etching liquid). The composition of the present invention is useful for the purposes of a bonding film, a prepreg, a copper foil, a build-up film, and a printed-wiring board, and is particularly useful for the purposes of a bonding film or a build-up film for high-speed communication.

The term "bonding film" as used herein is also referred to as an "adhesive film", and is used for, for example, an adhesive bonding between the core material of a flexible substrate and a coverlay film, an adhesive bonding between the core material of a frigid substrate and a copper foil or build-up film, and an adhesive bonding between the core materials themselves of the flexible or rigid substrates. The term "build-up film", also known as "interlayer insulating material", is utilized in the fine wiring layer of a substrate.

### DETAILED DESCRIPTION OF THE INVENTION

The present invention is directed to a heat-curable resin composition including: (A) an aromatic cyclic imide compound having a weight average molecular weight of 5,000 to 100,000; (B) an aliphatic cyclic imide compound having a weight average molecular weight of 100 to 2,000; (C) an epoxy resin having two or more epoxy groups in one molecule; (D) a curing agent for epoxy resin; (E) a curing catalyst; and (F) an inorganic filler, wherein the heat-curable resin composition contains the components (A) to (E) in a total amount of 5 to 99% by mass based on the overall composition.

The present invention will be described in greater detail hereunder.

### (A) Aromatic cyclic imide compound having a weight average molecular weight of 5,000 to 100,000

The component (A) is an aromatic cyclic imide compound having a weight average molecular weight of 5,000 to 100,000.

The term "aromatic cyclic imide compound" as used herein refers to a compound where a cyclic imide group is directly bonded to an aromatic ring. The aromatic cyclic imide compound may be used to obtain a cured product which is excellent in handleability of an uncured resin film and in heat and de-smear resistances.

It is preferred that the aromatic cyclic imide resin as the component (A) include at least one aromatic cyclic imide selected from aromatic cyclic imides represented by formulae (1) and (2) defined as 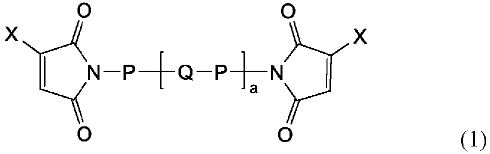
wherein, in the formula (1), P and Q are independently divalent groups represented by formulae defined as
   **P:** 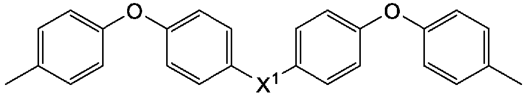
   Q: 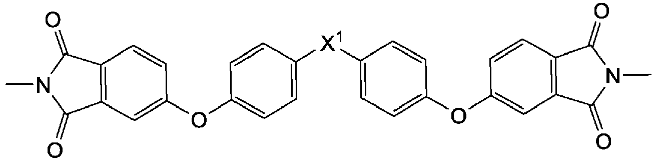
   wherein each X¹ independently represents a divalent group selected from formulae defined as

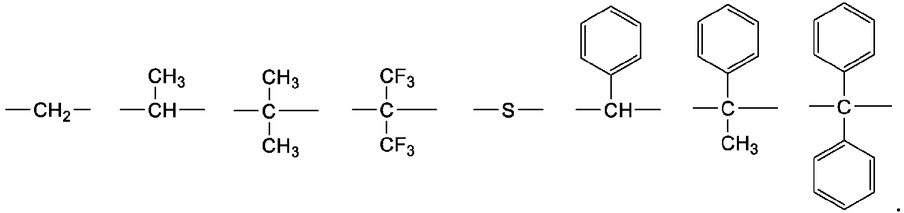

In the formula (1), a is a number of 1 to 40, and X represents a hydrogen atom or a methyl group.

It is preferred in terms of raw material availability that X¹ in the formula (1) be -CH₂- or -C(CH₃)₂-.

In the formula (1), a is a number of 1 to 40, preferably a number of 5 to30.

In the formula (1), X represents a hydrogen atom or a methyl group, preferably a hydrogen atom. 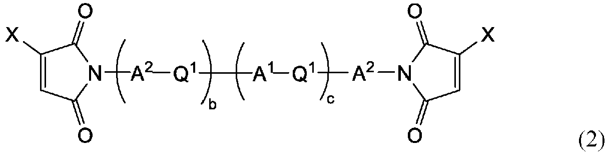 wherein, in the formula (2), Q¹ independently represents a divalent group represented by a formula defined as
**Q¹**: 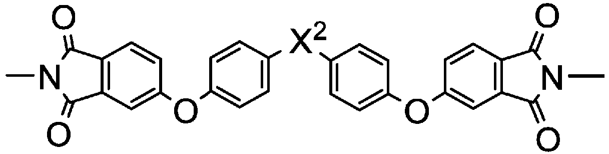 wherein X² independently represents a divalent group selected from formulae defined as

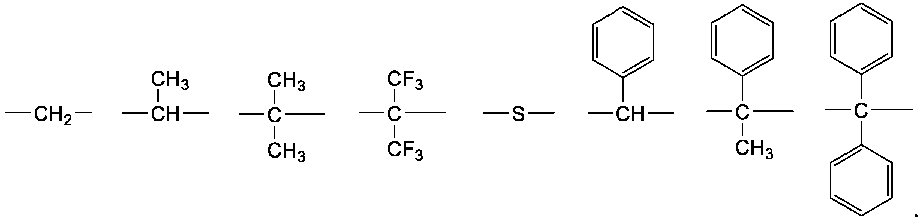

In addition, in the formula (2), b is a number of 1 to 50, c is a number of 1 to 50, and A¹ and A² each independently represents a divalent group represented by formula (3) or (4) defined as 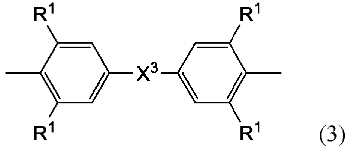 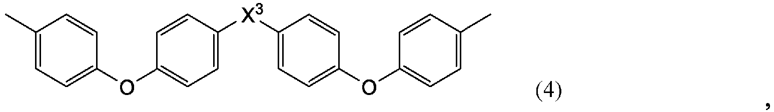 wherein, in the formulae (3) and (4), X³ is a divalent group selected from formulae defined as 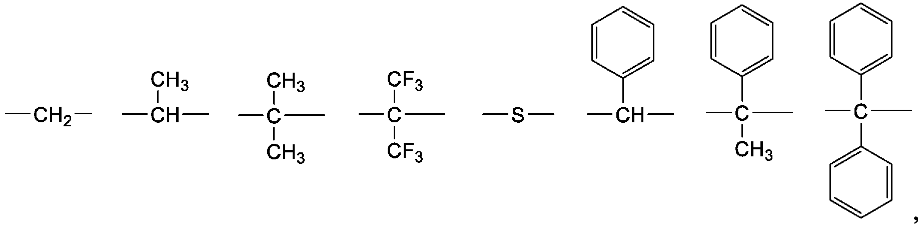 wherein each R¹ in the formula (3) independently represents a hydrogen atom, a chlorine atom, or an aliphatic hydrocarbon group having 1 to 6 carbon atoms. X represents a hydrogen atom or a methyl group.

It is preferred in terms of raw material availability that X² in the formula (2) be -CH₂- or -C(CH₃)₂-.

In the formula (2), b is a number of 1 to 50, preferably a number of 1 to40.

In the formula (2), c is a number of 1 to 50, preferably a number of 1 to40.

In the formula (2), A¹ and A² each independently represents a group represented by the formula (3) or (4) above.

It is preferred in terms of raw material availability that each X³ in the formulae (3) and (4) be -CH₂- or -C(CH₃)₂-.

Each R¹ in the formula (3) independently represents a hydrogen atom, a chlorine atom, or an aliphatic hydrocarbon group having 1 to 6 carbon atoms.

Examples of the aliphatic hydrocarbon group, having 1 to 6 carbon atoms, represented by R¹ in the formula (3) include, for example, a methyl group, an ethyl group, an n-propyl group, an isopropyl group, an n-butyl group, a t-butyl group, and a cyclohexyl group. There may be used those containing groups in which some or all of the hydrogen atoms in these groups are substituted by halogen atoms such as F, Cl and Br, and examples of which include those with trifluoropropyl group. It is preferred in terms of raw material availability that R¹ be a hydrogen atom or an aliphatic hydrocarbon group having 1 to 3 carbon atoms. X may be a hydrogen atom or a methyl group as in the formula (1) but preferably is a hydrogen atom.

It is preferred that the aromatic cyclic imide compound represented by the formula (2) be such that A¹ and A² are groups that are distinctive from each other. For example, it is preferable that A¹ is a group represented by the formula (3) while A² is a group represented by the formula (4), or that A¹ is a group represented by the formula (4) while A² is a group represented by the formula (3).

A bonding pattern of the repeating units with the repetition numbers b and c in the cyclic imide compound as defined by the formula (2) may be block or random. However, in terms of the mechanical strength or dielectric characteristics (particularly of achieving low dielectric tangent) of the cured product, a block bonding pattern is preferred.

The aromatic cyclic imide compound shown by the formula (1) and the aromatic cyclic imide compound shown by the formula (2) each contains a bisphenol structure within a single molecule, enabling their manufacture without using N-Methyl-2-pyrrolidone (NMP). They also exhibit excellent solvent solubility not only in NMP but also other types of solvents. A cyclic imide compound having a bisphenol structure is also preferred in terms of raw material availability. Examples of such bisphenol structures contained in the aromatic cyclic imide compound shown by the formula (1) and in the aromatic cyclic imide compound shown by the formula (2) include bisphenol A, bisphenol F, bisphenol E, and bisphenol AF among which, although not limited to the followings, bisphenol A and bisphenol F are preferred. The aromatic cyclic imide compound shown by the formula (1) and the aromatic cyclic imide compound shown by the formula (2) having the above-defined ranges of a, b, and c result in a favorable balance between solubility in a solvent and film-forming ability when uncured and the toughness and heat resistance of the resultant cured product.

The aromatic cyclic imide compound as the component (A) has a weight average molecular weight of 5,000 to 100,000, preferably of 7,000 to 80,000, more preferably of 8,000 to 60,000. Weight average molecular weights within these ranges allow the aromatic cyclic imide compound as the component (A) to be stably solubilized into solvents and ensure wettability to a base material. They also make un-cured film less likely to, for example, crack, thus resulting in a favorable film. Here, the term "weight average molecular weight" as used herein refers to a weight average molecular weight that is measured by gel permeation chromatography (GPC) using polystyrene as a reference substance under the following conditions.

### [GPC Measurement Conditions]

Developing solvent: Tetrahydrofuran
Flow rate: 0.35 mL/min
Detector: Differential refractive index detector (RI)
Column: TSK-gel H type (manufactured by Tosoh Corporation
Column temperature: 40°C
Sample injection volume: 5 µL (THF solution with a concentration of 0.2% by mass)

The aromatic cyclic imide compound as the component (A) defined by the formula (1) or (2) can be produced using a method that is described in, for example, JP-A-2021-017485.

The aromatic cyclic imide compound as the component (A) may be used alone, or two or more of them may be used in combination.

Further, the component (A) is preferably contained therein in an amount of 5 to 70% by mass, more preferably of 5 to 60% by mass, and even more preferably of 6 to 50% by mass based on the whole composition of the present invention.

### (B) Aliphatic cyclic imide compound having a weight average molecular weight of 100 to 2,000

The component (B) is an aliphatic cyclic imide compound having a weight average molecular weight of 100 to 2,000. The term "aliphatic cyclic imide compound" as used herein refers to a compound whose linker moieties between the two cyclic imide groups are all formed of aliphatic chains and contain no aromatic ring. The compound may contain heteroatom(s). Examples of heteroatoms include an oxygen atom, a nitrogen atom, and a sulfur atom. The aliphatic cyclic imide compound may be used to enhance the handling properties of an uncured resin film and reduce the melt viscosity of the resin composition, which thereby enhances the moldability or laminating property thereof. The compound is also effective for enhancing adhesivity on a metal such as copper.

It is preferred that the aliphatic cyclic imide compound as the component (B) be an aliphatic cyclic imide compound represented by a formula (5) defined in the following as 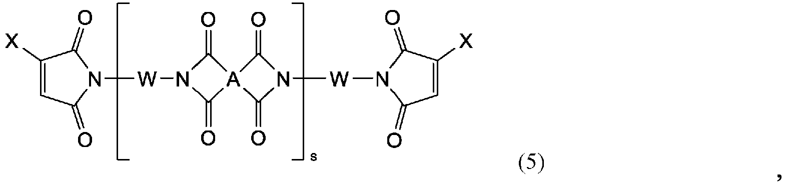 wherein, in the formula (5), each A independently represents a tetravalent organic group having an aliphatic cyclic structure, each X represents a hydrogen atom or a methyl group, each W independently represents a divalent aliphatic hydrocarbon group having 5 to 25 carbon atoms which may contain heteroatom(s), and s is 0 to 10.

In the formula (5), each A independently represents a tetravalent organic group having an aliphatic cyclic structure. Each X represents a hydrogen atom or a methyl group of which a methyl group is preferable in terms of reducing viscosity.

Each W in the formula (5) is a linear or branched alkylene group having 5 to 25 carbon atoms or a divalent aliphatic hydrocarbon group represented by any one of the structures defined in the following as 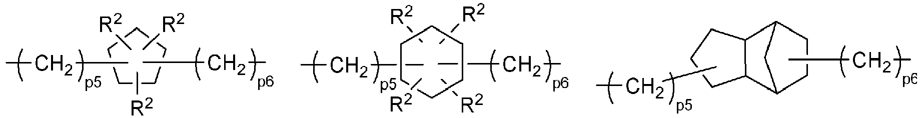 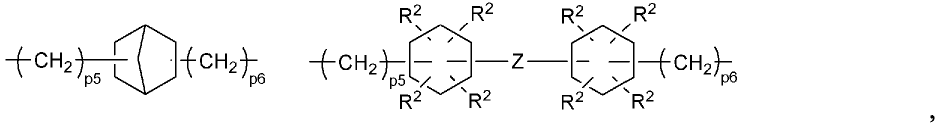 wherein p⁵ and p⁶ are each a number of 0 to 4 and may be identical to or different from each other, each R² independently represents a hydrogen atom or a linear or branched alkyl group having 1 to 20 carbon atoms, Z is an oxygen atom, a sulfur atom, or a methylene group, and wherein bonds in the above formulae that are yet unbonded to substituent groups are to be bonded to nitrogen atoms forming cyclic imide structures in the formula (5). It is preferred that W in the formula (5) be a linear or branched alkylene group having 6 to 20 carbon atoms, more preferably a branched alkylene group having 6 to 20 carbon atoms.

In the above formulae, p⁵ and p⁶ are each a number of 0 to 4, preferably of 0 to 2, and may be identical to or different from each other. Each R² independently represents a hydrogen atom or a linear or branched alkyl group having 1 to 20 carbon atoms, and it is preferred that R² be a hydrogen atom or a linear or branched alkyl group having 1 to 10 carbon atoms, more preferably a hydrogen atom or a linear alkyl group having 1 to 10 carbon atoms. Z is an oxygen atom, a sulfur atom or a methylene group.

s in the formula (5) is 0 to 10, preferably 0 to 5, more preferably 0 to 3, and it is even more preferred that s = 0.

The aliphatic cyclic imide compound represented by the formula (5) has a weight average molecular weight (Mw) of 100 to 2,000, preferably of 250 to 1,500, and more preferably of 300 to 1,000. A weight average molecular weight greater than 2,000 may result in a resin composition whose melt viscosity is not lowered at high temperatures, which therefore may result in a deteriorated mouldability or adhesivity of the resin composition.

The aliphatic cyclic imide compound as the component (B) may be used alone or two or more of them may be used in combination.

The component (B) is preferably contained therein in an amount of 5 to 150 parts by mass, more preferably of 12 to 90 parts by mass, and even more preferably of 15 to 80 parts by mass based on 100 parts by mass of the component (A).

### (C) Epoxy resin having two or more epoxy groups in one molecule

The heat-curable resin composition of the present invention uses, as the component (C), an epoxy resin having two or more epoxy groups in one molecule. The epoxy resin formulated therein may enhance adhesivity or improve other mechanical properties of the claimed resin composition.

It is preferred from the viewpoints of reactivity or storability that the component (C) be an epoxy resin having a glycidyl group.

Examples of the component (C) include a phenol novolac type epoxy resin, a bisphenol A type epoxy resin, a bisphenol F type epoxy resin, a biphenol type epoxy resin, a naphthalene type epoxy resin, an anthracene type epoxy resin, a naphthol type epoxy resin, a xylylene type epoxy resin, a biphenyl type epoxy resin, a biphenyl aralkyl type epoxy resin, a triphenylmethane type epoxy resin, an alicyclic type epoxy resin, a glycidylamine type epoxy resin, a dicyclopentadiene type epoxy resin, a stilbene type epoxy resin, a sulfur atom-containing epoxy resin and a phosphorus atom-containing epoxy resin. It is preferred in terms of compatibility or wettability to a base material that the component (C) liquid at room temperature (25°C) be used.

It is preferred that the component (C) be added in an amount of 0.05 to 25 parts by mass, more preferably of 0.1 to 20 parts by mass, per 100 parts by mass of a total of the components (A) and (B). The amount of the component (C) within these ranges ensures an optimal curing speed during molding and therefore is preferable. The resultant cured product achieves a favorably balanced performance in terms of both heat and moisture resistances, and is more likely to have a desired low dielectric property.

The epoxy resin as the component (C) may be used alone or two or more of them may be used in combination.

### (D) Curing agent for epoxy resin

The heat-curable resin composition of the present invention uses a curing agent for epoxy resin as the component (D). The curing agent for epoxy resin contained therein may improve mechanical properties, regulate curing behavior, and reduce the moisture absorption effect. Examples of such curing agent for epoxy resin include a phenol curing agent, an amine curing agent, an acid anhydride curing agent, and an active ester curing agent.

It is preferred from the viewpoints of reactivity or storability that the component (D) be an amine curing agent. It is preferred that the amine curing agent be an amine compound, more preferably an aromatic amine compound. An aliphatic amine compound exhibits excessively high nucleophilicity, which may substantially compromise storability or lead to a cured product with elevated moisture absorbency.

It is preferred that the component (D) be added thereto in an amount of 0.05 to 25 parts by mass, more preferably of 0.1 to 20 parts by mass per 100 parts by mass of a total of the components (A) and (B).

The curing agent for epoxy resin as the component (D) may be used alone or two or more of them may be used in combination.

### (E) Curing catalyst

The component (E) serves as a curing catalyst for promoting the curing reaction of the heat-curable resin composition of the present invention. It is added thereinto to initiate or accelerate the cross-linking reaction between the cyclic imide compounds (components A and B), the epoxy resin (component C), and the curing agent (component D). Examples of the catalyst include a thermal radical polymerization initiator, an anion polymerization initiator, and a quaternary onium salt.

A thermal radical polymerization initiator primarily facilitates the crosslinking of maleimide compounds (X = H in formulae (1) and (2)) within cyclic imide compounds, while a quaternary onium salt mainly promotes the crosslinking between epoxy resins and their curing agents. Anionic polymerization catalysts, including basic compounds such as imidazoles and tertiary amines as well as organic phosphorus compounds, are preferred due to their ability to promote balanced crosslinking of the respective components. It is particularly preferred that an imidazole be used.

It is preferred that the component (E) be added thereto in an amount of 0.05 to 10 parts by mass, more preferably of 0.1 to 5 parts by mass, per 100 parts by mass of a total of the components (A) to (D). When a further heat-curable resin to be described hereunder is added to the composition, it is preferred that the component (E) be added within a range of 0.05 to 10 parts by mass, particularly preferably of 0.1 to 5 parts by mass, per 100 parts by mass of a total of the components (A) to (D) and the further heat-curable resin as described hereunder. The component (E) in an amount within the above range is preferable because it results in a stable curing during the molding of the heat-curable resin composition of the present invention. The component (E) in an amount within the above range is also preferable because it achieves a favorably balanced performance in terms of both heat and moisture resistances of the resultant cured product. The catalyst as the component (E) may be used alone or two or more of them may be used in combination.

In addition, the heat-curable resin composition of the present invention contains the compositions (A) to (E) in a total amount of 5 to 99% by mass, preferably of 10 to 90% by mass, even more preferably of 20 to 80% by mass, based on the overall composition.

### (F) Inorganic filler

The heat-curable resin composition of the present invention may further contain (F) an inorganic filler. The inorganic filler may be added for improving the strength and rigidity of the cured product of the heat-curable resin composition of the present invention, or for adjusting a thermal expansion coefficient and the dimension stability of the cured product. As such inorganic filler, there may be used those that are generally added to an epoxy resin composition or a silicone resin composition, but it is preferable for reducing the overall dielectric tangent of the composition that the inorganic filler be particles of silica such as a spherical silica, a molten silica, and a crystalline silica, or of boron nitride.

Although there are no particular restrictions on the average particle diameter and shape of the inorganic filler, a spherical silica having an average particle diameter of 0.1 to 5 µm is preferably used from the viewpoints of workability of the substrate. Here, the average particle diameter is a value calculated as a mass average value of D₅₀ (or median diameter) in a particle size distribution measurement conducted by a laser diffraction method.

Further, for the sake of property improvement, it is preferred that the inorganic filler be one that has already been surface-treated with a silane coupling agent having organic groups capable of reacting with reactive groups in the components (A) to (D). Examples of such silane coupling agent include an epoxy group-containing alkoxysilane, an amino group-containing alkoxysilane, a (meth)acrylic group-containing alkoxysilane, and an alkenyl group-containing alkoxysilane.

Among these silane coupling agents, a (meth)acrylic group-containing alkoxysilane and/or an amino group-containing alkoxysilane may be suitably used, and specific examples thereof include 3-methacryloxypropyltrimethoxysilane, 3-acryloxypropyltrimethoxysilane, N-phenyl-3-aminopropyltrimethoxysilane, N-2-(aminoethyl)-3-aminopropyltrimethoxysilane, and 3-aminopropyltrimethoxysilane.

In the heat-curable resin composition of the present invention, the component (F) is present in an amount of 1 to 95% by mass, preferably of 10 to 90% by mass, and more preferably of 20 to 80% by mass based on the total composition.

### Further additives

The heat-curable resin composition of the present invention may be supplemented with a variety of additives as needed. Examples of such additives are as exemplified below.

### Heat-curable resin having reactive groups capable of reacting with maleimide groups

In the present invention, there may further be added a heat-curable resin having reactive groups capable of reacting with the components (A) to (D). Although there are no restrictions on the type of such curable resin, examples of which may include various resins such as a melamine resin, a silicone resin, cyclic imide resins other than the components (A) and (B), a urea resin, a heat-curable polyimide resin, a modified polyphenylene ether resin, a heat-curable acrylic resin, and an epoxy-silicone hybrid resin.

Further, examples of the reactive groups capable of reacting with cyclic imide groups include a cyclic imide group, a hydroxyl group, an acid anhydride group, an alkenyl group such as an allyl group and a vinyl group, a (meth)acryloyl group, and a thiol group but it is preferred in terms of reactivity that the reactive group be selected from a cyclic imide group, a hydroxyl group, and an alkenyl group, and it is more preferred in terms of dielectric properties that the group be an alkenyl group or a (meth)acryloyl group.

It is preferred that the amount thereof be 0 to 40% by mass based on the total mass of the heat-curable resin composition of the present invention.

### Others

In addition to the above additives, there may also be added, for example, a non-functional silicone oil, a reactive diluent, a thermoplastic resin, a thermoplastic elastomer, an organic synthetic rubber, a photosensitizer, a light stabilizer, a polymerization inhibitor, a flame retardant, a pigment, a dye, an adhesion aid such as a silane coupling agent, and an ion-trapping agent.

Further, any of the above silane coupling agents such as an epoxy group-containing alkoxysilane, an amino group-containing alkoxysilane, a (meth)acryloyl group-containing alkoxysilane and an alkenyl group-containing alkoxysilane that are used for surface-treating the inorganic filler, may be separately added to the heat-curable resin composition of the present invention. Specific examples of the silane coupling agents include those same as already listed.

The heat-curable resin composition of the present invention may also be handled as a varnish or a slurry after being dissolved into an organic solvent. By turning the composition into a varnish, a film can be formed easily, and a glass cloth made of an E glass, a low-dielectric glass, a quartz glass or the like can be easily coated and impregnated therewith. There are no restrictions on the organic solvent so long as it is capable of dissolving the components (A) to (D) and/or the curable resin, as one of the other additives, that has reactive groups capable of reacting therewith; there may be listed, for example, anisole, tetralin, mesitylene, xylene, toluene, tetrahydrofuran (THF), dimethylformamide (DMF), dimethyl sulfoxide (DMSO), and acetonitrile. Of these, aromatic organic solvents, such as anisole, tetralin, mesitylene, xylene, and toluene, are preferable. A ketone solvent having a boiling point as low as 100°C or less, such as methyl ethyl ketone (MEK) and methyl isobutyl ketone (MIBK), is commonly used to produce varnishes or form slurries. However, the cyclic imide compound, used as the component (A) in the present invention, exhibits low solubility in these ketone solvents, which might be unsuitable for use. Here, these organic solvents may be used alone or two or more of them may be used in combination.

As a method for producing the heat-curable resin composition of the present invention according to the present invention, there may be employed, for example, a method where the components (A), (B), (C), (D), (E), and (F) as well as other additives that are added if necessary are mixed by, for example, a planetary mixer (manufactured by Inoue Mfg., Inc.) or a mixer "Thinky Conditioning Mixer" (manufactured by Thinky Corporation).

The heat-curable resin composition may be formed into an uncured resin sheet or an uncured resin film by a process in which the above-mentioned varnish is applied to a base material, followed by volatilizing the organic solvent. This uncured resin sheet or film may be further cured to form a cured resin sheet or a cured resin film. Methods of producing sheets and films will be exemplified herein below but the methods shall not be limited to these.

For example, after applying to a base material the heat-curable resin composition dissolved in the organic solvent (i.e. varnish), the organic solvent is eliminated by performing heating at a temperature of normally not lower than 80°C, preferably not lower than 100°C for 0.5 to 20 min, and a strong cured resin film with a flat surface can then be formed by further performing heating at a temperature of not lower than 130°C, preferably not lower than 150°C for 0.5 to 10 hours. The temperature in the drying step for eliminating the organic solvent and the temperature in the subsequent heating and curing step may each be a constant temperature; it is preferred that these temperatures be raised in a step-wise manner. Thus, not only the organic solvent can be efficiently eliminated out of the composition, but the curing reaction of the resins can also take place efficiently. Examples of methods for applying the varnish include those employing a spin coater, a slit coater, a sprayer, a dip coater, and a bar coater; there are no particular restrictions on such method.

As a base material, there may be used a conventional resin base material, examples of which include polyolefin resins such as a polyethylene (PE) resin, a polypropylene (PP) resin and a polystyrene (PS) resin; and polyester resins such as a polyethylene terephthalate (PET) resin, a polybutylene terephthalate (PBT) resin and a polycarbonate (PC) resin. The surface of such base material may also be subjected to a mold release treatment. Further, there are no particular restrictions on the thickness of a coating layer; a thickness after distilling away the solvent is in a range of 1 to 200 µm, preferably of 3 to 150 µm. A cover film may also be provided on such a coating layer. Instead, it may also be directly used by preliminarily mixing the components in advance, and then extruding the mixture into the shape of a sheet or a film using a melt-kneading machine.

The film obtained in this way may be used as a bonding film or a build-up film. Such bonding film may be used between the core material for manufacturing a flexible printed-wiring board and a coverlay film or between an organic substrate and a build-up film. Further, the build-up film is used in a method for manufacturing a substrate, called as semi-additive process (SAP) or its modified method (M-SAP) for manufacturing a laminated or a printed-wiring board.

Here, there may be used a base material of copper foil on which an uncured or semi-cured film is formed in a same manner as mentioned above to produce a resin-clad copper foil. Alternatively, similar to the case already explained, the heat-curable resin composition may be dissolved in an organic solvent to prepare a varnish, followed by applying the varnish to a polyethylene terephthalate (PET) film that had been subjected to a mold release treatment, and then volatilizing the solvent to form a film, which is then attached to a copper foil and then the PET film is removed to thereby produce a resin-clad copper foil. The laminating conditions during this process are not particularly limited but it is preferred that the laminating process be performed by heating for 0.5 to 5 minutes at a heating temperature of 80 to 130°C and under a pressure of 0.1 to 1.0 MPa.

The copper foil to be used may have any roughness which is not particularly limited, but it is preferable, in terms of reducing the conductor loss, to use a product of copper foil whose portion of the surface in contact with an uncured or semi-cured heat-curable resin has a surface roughness, in terms of ten-point average roughness (Rz), of 1.5 µm or less. It is preferred in terms of reducing the conductor loss that the Rz be as small as possible, preferably 1.3 µm or less, more preferably 1.0 µm or less. Meanwhile, regarding adhesivity, a material having a small Rz is less likely to achieve an anchoring effect and tends to exhibit reduced adhesivity. However, the heat-curable resin composition of the present invention demonstrates strong adhesivity, which enables it to be used with copper foil of such a low roughness.

The copper foil for use may be produced by any method which is not particularly limited but it is generally and often produced by electrolysis or rolling, and electrolytic copper foils produced by electrolysis may be widely used. Additionally, regarding the copper foil for use, a copper foil that has undergone surface treatment for enhancing properties such as adhesivity, heat resistance, and chemical resistance may be utilized.

The copper foil may have any thickness which is not particularly limited but the one having a thickness in a range of 6 to 50 µm may typically be used. A thinner foil can be used in a form referred to as a "copper foil in combination with a carrier", which intends to enhance handleability by providing additional thickness using a carrier to be attached to the thin copper foil, and then the carrier is peeled off in a subsequent process.

Additionally, a fiber base material such as a glass cloth made of an E glass, a low-dielectric glass, a quartz glass or the like may be impregnated with the heat-curable resin composition of the present invention composition that has been turned into a varnish, followed by eliminating the organic solvent to achieve a semi-cured state, thereby allowing the product thus obtained to be used as a prepreg. Further, a laminate or printed-wiring board including multilayered ones can be produced by laminating such prepreg or copper foil.

This prepreg has a heat-curable resin composition and a fiber base material. The heat-curable resin composition is either the above heat-curable resin composition or a semi-cured product of the resin composition. Here, the term "semi-cured product" refers to a product in a state where the resin composition has been incompletely cured to the extent that the composition can actually be further cured. That is, the semi-cured product is a product of a state where the resin composition has been semi-cured which is termed as a "B-staged product". Meanwhile, an uncured state may also be referred to as A-stage. That is, the heat-curable resin composition may be a curable resin composition in a state of the A-stage, or be a heat-curable resin composition in a state of the B-stage. As described above, the fiber base material may for example be an E glass, a low-dielectric glass, a quartz glass, or even an S glass or T glass; while there may be employed any type of glass, a quartz glass cloth having low dielectric property is preferred in terms of taking advantage of the properties of the heat-curable resin composition. Here, the thickness of a generally used fiber base material is, for example, not smaller than 0.01 mm and not larger than 0.3 mm.

When producing a prepreg, it is preferred that the heat-curable resin composition be in the form of varnish as described above for impregnating the fiber base material, as a base material for forming the prepreg, with the resin composition. As a method for producing the prepreg, there may be employed, for example, a method where the fiber base material is at first impregnated with the heat-curable resin composition prepared in the form of a varnish, and is then dried. The fiber base material may be impregnated with the heat-curable resin composition by, for example, dipping the fiber base material into the heat-curable resin, or applying the heat-curable resin to the fiber base material. If necessary, the fiber base material may be repeatedly impregnated with the resin several times. Further, at that time, it is also possible to repeat impregnation using multiple resin compositions with different compositions and concentrations, whereby the composition and impregnation amount can eventually be adjusted to desired ones. The fiber base material impregnated with the heat-curable resin composition (resin varnish) is heated under a desired heating condition(s) of, for example, at 80 to 180°C for 1 to 20 min. By heating, there can be obtained a prepreg of the heat-curable resin composition of A-stage or B-stage. Here, heating performed in the above manner will volatilize the organic solvent from the varnish by which the organic solvent may be reduced or eliminated.

A laminate according to one embodiment of the present invention is one prepared by laminating an insulating layer containing or consisting of the cured product of the heat-curable resin composition; and a layer other than the insulating layer. A generally well-known laminate is a metal-clad laminate, particularly a copper-clad laminate. A metal-clad laminate has an insulating layer containing or consisting of the cured product of the heat-curable resin composition; and a metal foil arranged on both surfaces of the insulating layer. The metal-clad laminate may also be a single-sided metal-clad laminate with the metal foil being provided only on one surface of the insulating layer. Further, the insulating layer may be a layer consisting of the cured product of the heat-curable resin composition, a layer consisting of the cured product of the prepreg, or even a layer with multiple pieces of the cured product of the prepreg being laminated together. Further, a resin-clad copper foil may be used to produce a copper-clad laminate, or cured products of prepreg may be produced first, and then, in-between the cured products, metal foils may be laminated via bonding films made of the heat-curable resin composition to produce a metal-clad laminate.

There are no particular restrictions on methods for producing such laminate so long as the method used is a conventional method. For example, when using a prepreg, there may be employed a method where the laminate is produced in such a manner that one or multiple pieces of the prepreg are stacked together, and the metal foil such as a copper foil is then placed on one or both surfaces thereof in the vertical direction before performing heating and pressurization so as to mold them into an integrally laminated product.

The printed-wiring board according to one embodiment of the present invention is directed to the one containing the cured product of the curable resin composition. The insulating layer of the metal-clad laminate used for producing a printed-wiring board may be one produced using the aforementioned prepreg. The printed-wiring board may be produced by subjecting the metal-clad laminate to circuit formation processing or multi-layered adhesion processing of know methods, such as drilling, metal plating processing, and metal foil etching.

There may be further performed the processes of (1) drilling an insulating layer, (2) roughening the insulating layer, and (3) forming a conductive layer, during the process of producing the printed-wiring board. These processes (1) and (3) may be performed in accordance with various known methods for manufacturing a printed-wiring board.

The process (1) is a process of drilling holes in the insulating layer by which holes such as via holes or through holes may be formed in the insulating layer. This process (1) can utilize techniques such as drilling, laser, or plasma processes depending on the formulation of resin composition used to form the insulating layer. The dimensions or shapes of the holes may be appropriately determined in accordance with the design of the printed-wiring board.

The process (2) is a process of roughening the insulating layer. This process (2) roughens the insulating layer while removing (de-smearing) a resin residue, referred to as "smear", having been produced in the process (1). The procedure and condition of the roughening process are not particularly restricted, so that procedures and conditions that are heretofore known and usually used to form an insulating layer of a printed wiring board can be used. The roughening process of the insulating layer may be carried out, for example, by a method in which a swelling treatment with a swelling solution, a roughening treatment with an oxidant, and a neutralizing treatment with a neutralizing solution are carried out sequentially in this order.

As described above, a metal foil, particularly of copper, tends to have decreased roughness in recent years for the purpose of reducing the conductor loss. A foil having a decreased toughness tends to exhibit a weakened anchoring effect and reduced adhesivity to a resin layer. Further, the roughening process incurs peeling which is problematic and will be discussed in greater detail below.

Examples of such swelling solution used in the roughening process include, but are not particularly limited to, an alkaline solution and a surfactant solution among which an alkaline solution is preferable. A swelling solution that is commercially available may be used and examples of such commercially available swelling solution include "Swelling Dip Securiganth P", "Swelling Dip Securiganth SBU", and "Swelling Dip Securigant P" all manufactured by Atotech Japan Co., Ltd. No particular restriction will be imposed on the swelling treatment using the swelling solution, but it can be carried out by, for example, soaking the insulating layer in the swelling solution at a temperature of 30 to 90°C for the period of 1 to 20 minutes. It is preferred in terms of suppressing the swelling of the resin in the insulating layer to a suitable level that the insulating layer be soaked in the swelling solution at 40 to 80°C for 5 to 15 minutes.

Examples of oxidants for use in the roughening process include, but are not particularly limited to, an alkaline permanganate solution having potassium permanganate or sodium permanganate dissolved in a sodium hydroxide aqueous solution. The roughening process with an oxidant such as the alkaline permanganate aqueous solution may be carried out preferably by soaking the insulating layer into the oxidant solution, heated to 60 to 100°C, for the period of 10 to 30 minutes. The concentration of the permanganate salt in the alkaline permanganate aqueous solution is preferably in a range of 5 to 10% by mass. A solution that is commercially available may be used therefor, and examples of such commercially available oxidant include alkaline permanganate aqueous solutions such as "Concentrate Compact CP" and "Dosing Solution Securiganth P" which are manufactured by Atotech Japan, Co., Ltd.

This oxidant is designed to dissolve smears, but it dissolves not only the smears but also the resin layer as well. On metal surfaces with low roughness, as explained in the above, the solution can penetrate the interface between the metal and the resin layer once the oxidant starts to melt the resin layer, leading to the resin readily peeling off. Resistance to such oxidants is therefore crucial. However, a resin with excessive resistance to these oxidants causes a problem that it fails to effectively desmear; that is, simply having high resistivity doesn't always yield favorable results. Therefore, the resin must possess an appropriate level of resistance to oxidants, strong adhesivity to prevent solution penetration at the interface, and good wettability with the metal.

The neutralization solution used in the roughening process is preferably an acidic aqueous solution, and examples of such commercially available neutralization solution include "Reduction Solution Securiganth P" manufactured by Atotech Japan Co., Ltd. Treatment with the neutralization solution can be carried out by soaking the surface, treated with the roughening process using the oxidant, in the neutralization solution at 30 to 80°C for 1 to 30 minutes. It is preferable in terms of, for example, workability to use a method where the object treated with the roughening process using the oxidant is soaked in the neutralization solution at 40 to 70°C for 5 to 20 minutes.

The process (3) is a process of forming a conductive layer by which the conductive layer is formed on the insulating layer. No particular restriction will be particularly imposed on the type of conductive material for use in the conductive layer. In a preferred embodiment, the conductive layer includes at least one metal selected from the group consisting of gold, platinum, palladium, silver, copper, aluminum, cobalt, chromium, zinc, nickel, titanium, tungsten, iron, tin, and indium. The conductive layer may be a single metal layer or a metal alloy layer. Examples of the metal alloy layer include a layer formed of a metal alloy of two or more metals selected from the group as listed in the above (for example, nickel-chromium alloy, copper-nickel alloy, and copper-titanium alloy). Among them, in view of versatility for forming the conductive layer, cost effectiveness, and patterning readiness, preferred are single metal layers of chromium, nickel, titanium, aluminum, zinc, gold, palladium, silver, or copper; and metal alloy layers of a nickel-chromium alloy, a copper-nickel alloy, and a copper-titanium alloy. Among them, more preferred are single metal layers of chromium, nickel, titanium, aluminum, zinc, gold, palladium, silver, or copper, or a metal alloy layer of a nickel-chromium alloy. A single metal layer of copper is still more preferred.

The conductive layer may be of a single-layer structure or of a multiple-layer structure that includes two or more laminated single metal layers or metal alloy layers formed of different types of metal or metal alloys. In the case that the conductive layer is of the multiple layer structure, the layer contacting with the insulating layer is preferably a single metal layer of chromium, zinc, or titanium, or a metal alloy layer of a nickel-chromium alloy. The thickness of the conductive layer is generally in a range of 3 to 35 µm, while preferably in a range of 5 to 30 µm, although these values depend on the intended design of the printed wiring board. In addition, the conductive layer may also be formed by plating.

### WORKING EXAMPLES

The present invention will be described in detail hereunder with reference to working and comparative examples; the present invention shall not be limited to the following working examples. The term "room temperature" as used in the working and comparative examples refers to 25°C.

The components used in the working and comparative examples are shown below. Here, the weight average molecular weight (Mw) as used hereunder refers to a value measured by gel permeation chromatography (GPC) using polystyrene as a reference substance under the following measurement conditions.

### [GPC measurement conditions]

Developing solvent: Tetrahydrofuran (THF)
Flow rate: 0.35 mL/min
Detector: Differential refractive index detector (RI)
Column: TSK-GEL H type (manufactured by Tosoh Corporation)
Column temperature: 40°C
Sample injection volume: 5 µL (THF solution with a concentration of 0.2% by mass)

### (A) Aromatic cyclic imide compound having a weight average molecular weight of 5,000 to 100,000

### [Synthesis example 1]

Here, 65.06 g (0.125 mol) of 2,2-bis[4-(2,3-dicarboxyphenoxy)phenyl] propane dianhydride, 61.59 g (0.150 mol) of 2,2-bis[4-(4-aminophenoxy)phenyl]propane, and 250 g of anisole were added to a 1 L glass four-necked flask equipped with a stirrer, a Dean-Stark tube, a cooling condenser and a thermometer, followed by stirring them at 80°C for three hours to synthesize an amic acid. Next, the temperature was directly raised to 150°C, where stirring was performed for another 2 hours while distilling away water generated as a by-product, thereby producing a diamine compound with each end being blocked with an amino group (this type of diamine compound is also referred to simply as "diamine compound" hereunder).

After cooling the flask containing the solution of the resultant diamine compound to room temperature, 5.39g (0.055 mol) of maleic anhydride was added thereto, followed by performing stirring at 80°C for three hours to synthesize a maleamic acid. Then, the temperature was directly raised to 150°C, where stirring was performed for 2 hours while distilling away water generated as a by-product, thereby obtaining a varnish of aromatic bismaleimide compound defined by the formula (A-1) as shown below: 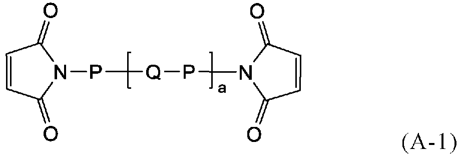 wherein, in the formula (A-1), a ≈ 8 (average value) and P and Q respectively and independently represent divalent groups defined in the following by formulae:
P: 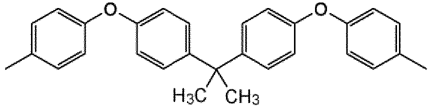
**Q**:

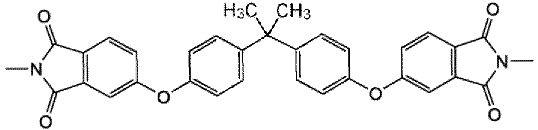

This aromatic bismaleimide compound had a weight average molecular weight (Mw) of 25,300. Anisole was then added to the varnish in a way such that non-volatile constituents of the vanish would be in an amount of 25% by mass

### [Synthesis example 2]

Here, 65.06 g (0.125 mol) of 2,2-bis[4-(2,3-dicarboxyphenoxy)phenyl] propane dianhydride, 35.26 g (0.115 mol) of 4,4'-methylenebis(2,6-diethylaniline), and 250 g of anisole were added to a 1 L glass four-necked flask equipped with a stirrer, a Dean-Stark tube, a cooling condenser and a thermometer, followed by stirring them at 80°C for three hours to synthesize an amic acid. Next, the temperature was directly raised to 150°C, where stirring was performed for 2 hours while distilling away water generated as a by-product, thereby synthesizing a copolymer.

Then, 7.05 g (0.015 mol) of 2,2-bis[4-(4-aminophenoxy)phenyl]propane was added to the flask containing the copolymer solution cooled to room temperature, followed by performing stirring at 80°C for three hours to synthesize an amic acid. After that, the temperature was directly raised to 150°C, where stirring was performed for 2 hours while distilling away water generated as a by-product, thereby synthesizing a diamine compound.

After cooling the flask containing the solution of the resultant diamine compound to room temperature, 1.45 g (0.015 mol) of maleic anhydride was added thereto, followed by performing stirring at 80°C for three hours to synthesize a maleamic acid. Then, the temperature was directly raised to 150°C, where stirring was performed for 2 hours while distilling away water generated as a by-product, thereby obtaining a varnish of aromatic bismaleimide compound represented in the following by a formula (A-2) defined as 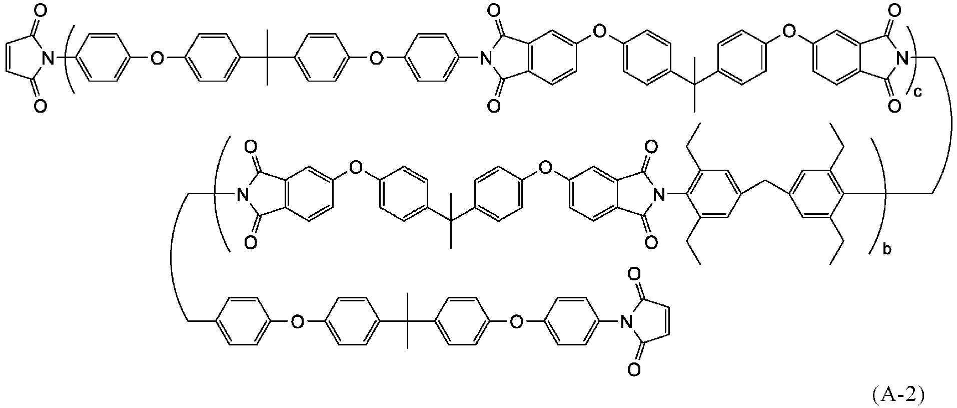 where b ≈ 8 and c ≈ 1 (respectively average values).

The aromatic bismaleimide compound had a wight average molecular weight (Mw) of 30,800. Anisole was then added to the varnish in a way such that non-volatile constituents of the varnish would be in an amount of 25% by mass.

### [Synthesis example 3]

Here, 65.06 g (0.125 mol) of 2,2-bis[4-(2,3-dicarboxyphenoxy)phenyl] propane dianhydride, 61.59 g (0.150 mol) of 2,2-bis[4-(4-aminophenoxy)phenyl]propane, and 250 g of anisole were added to a 1 L glass four-necked flask equipped with a stirrer, a Dean-Stark tube, a cooling condenser and a thermometer, followed by stirring them at 80°C for three hours to synthesize an amic acid. Next, the temperature was directly raised to 150°C, where stirring was performed for another 2 hours while distilling away water generated as a by-product, thereby producing a diamine compound.

After cooling the flask containing the solution of the resultant diamine compound to room temperature 6.16g (0.055 mol) of citraconic anhydride was added thereto, followed by performing stirring at 80°C for three hours to synthesize a maleamic acid. Then, the temperature was directly raised to 150°C, where stirring was performed for 2 hours while distilling away water generated as a by-product, thereby obtaining a varnish of aromatic biscitraconimide compound represented in the following by a formula (A-3) defined as 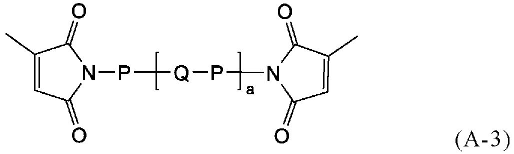 wherein, in the formula (A-3), a ≈ 8 (Average value) and P and Q respectively and independently represent divalent groups defined in following by formulae defined as
P: 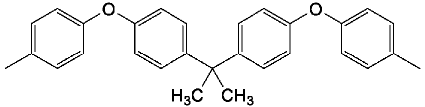
Q:

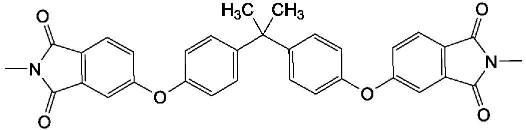

This aromatic biscitraconimide compound had a weight average molecular weight (Mw) of 25,300. Anisole was then added to the varnish in a way such that non-volatile constituents of the vanish would be in an amount of 25% by mass.

### Other cyclic imide compounds

(A-4): Bismaleimide compound (Trade name: BMI-5000; Mw: 18,000; manufactured by Designer Molecules Inc; used as a comparative example) represented in the following by a formula defined as 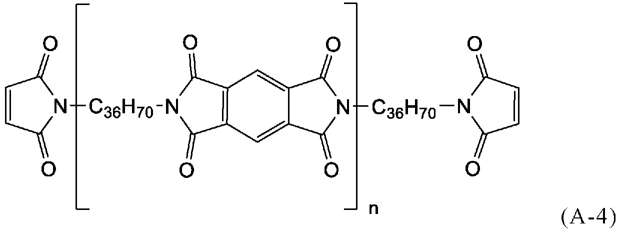 wherein -C₃₆H₇₀- represents a dimer acid frame-derived hydrocarbon group, and n ≈ 10 (Average value).
(A-5): Biscitraconimide compound (Mw: 18,000; used as a comparative example) represented in the following by a formula defined as 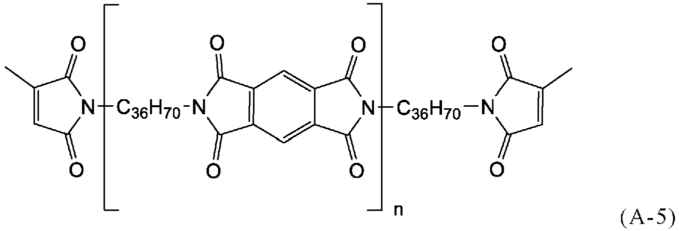 wherein -C₃₆H₇₀- represents a dimer acid frame-derived hydrocarbon group, and n ≈ 10 (Average value).
(A-6): 4,4'-diphenylmethane bismaleimide (BMI-1000, Mw: 520, manufactured by Daiwa Kasei Industry Co., Ltd.)
(A-7): Bisphenol A diphenyl ether bismaleimide (BMI-4000, Mw: 670, manufactured by Daiwa Kasei Industry Co., Ltd; used as a comparative example)

### [Synthesis example 4]

Here, 77.55 g (0.149 mol) of 2,2-bis[4-(2,3-dicarboxyphenoxy)phenyl] propane dianhydride, 61.59 g (0.150 mol) of 2,2-bis[4-(4-aminophenoxy)phenyl]propane, and 250 g of anisole were added to a 1 L glass four-necked flask equipped with a stirrer, a Dean-Stark tube, a cooling condenser and a thermometer, followed by stirring them at 80°C for three hours to synthesize an amic acid. Then, the temperature was directly raised to 150°C, where stirring was performed for 2 hours while distilling away water generated as a by-product, thereby producing a diamine compound. After cooling the flask containing the solution of the resultant diamine compound to room temperature, 0.79 g (0.010 mol) of maleic anhydride was added thereto, followed by performing stirring at 80°C for three hours to synthesize a maleamic acid. Then, the temperature was directly raised to 150°C, where stirring was performed for 2 hours while distilling away water generated as a by-product to obtain a varnish of aromatic bismaleimide compound represented in the following by a formula (A-8) defined as 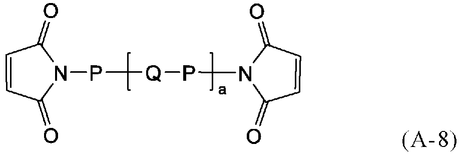 wherein, in the formula (A-8), a ≈ 30 (Average value) and P and Q respectively and independently represent divalent groups defined in the following by formulae:
P: 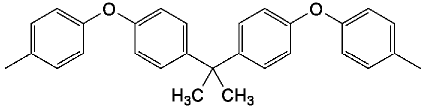
Q:

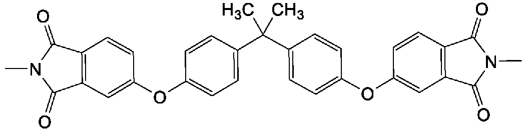

It, however, turned out that this varnish had an excessively high viscosity at room temperature, and was in a state in which the stirring could not be performed. This aromatic bismaleimide compound had a weight average molecular weight (Mw) of 162,000, and was extremely difficult to handle. For this reason, it was determined not to use this bismaleimide for evaluation.

### (B) Aliphatic cyclic imide compound having a weight average molecular weight of 100 to 2,000

### [Synthesis example 5]

Here, 202 g (1.0 mol) of 1,12-diaminododecane, 245 g (2.5 mol) maleic anhydride, 82 g (1.0 mol) of sodium acetate, and 204 g (2.0 mol) of acetic anhydride were added to 250 g of N-methylpyrrolidone, followed by stirring them at 100°C for five hours. Later, 500 g of toluene was added, followed by performing water washing and dewatering before distilling away the solvent under reduced pressure, thereby obtaining an aliphatic bismaleimide compound represented in the following by a formula (B-1) defined as

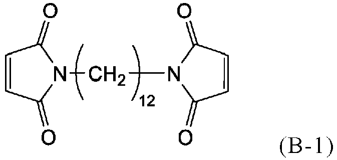

The aliphatic bismaleimide compound had a weight-average molecular weight (Mw) of 500.
(B-2) Aliphatic bismaleimide compound (Trade name: BMI-TMH by Daiwakasei Industry Co., LTD.; weight-average molecular weight of 450) represented in the following by a formula defined as 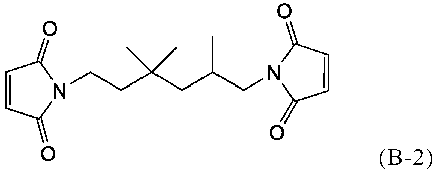
(B-3) Aliphatic biscitraconimide compound (Weight-average molecular weight of 470) represented in the following by a formula defined as

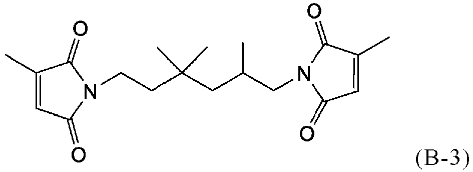

### (C) Epoxy resin having two or more epoxy groups in one molecule

(C-1): Bisphenol A type epoxy resin (Trade name: "jER-828EL" manufactured by Mitsubishi Chemical Corporation
(C-2) Multi-functional epoxy resin (Trade name: EPPN-501 manufactured by Nippon Kayaku Co.,Ltd.)

### (D) Curing agent for epoxy resin

(D-1): Amine curing agent (4,4'-diaminodiphenylmethane manufacture by TCI Co., Ltd.)
(D-2): Phenol novolac resin (Trade name: TD-2131 manufacture by DCI Co., Ltd.)

### (E) Curing catalyst

(E-1): 2-ethyl-4-methylimidazole (Trade name: 2E4MZ manufactured by SHIKOKU CHEMICALS CORPORATION)
(E-2): Triphenylphosphine (Trade name: TPP manufactured by HOKKO CHEMICAL INDUSTRY CO., LTD.)
(E-3): Dicumyl peroxide (Trade name: PERCUMYL^{®} D manufactured by NOF Corporation.)

### (F)Inorganic filler

(F-1): Slurry of toluene dispersing liquid of spherical silica having an average diameter of 0.5 µm and having a solid content of 75% by mass (Trade name: 5SV-CT1 manufactured by

### ADMATECHS COMPANY LIMITED)

### Preparation of resin varnish and compatibility

At the compounding ratios shown in Tables 1 to 3, the components listed in Tables 1 to 3 but the component (E) were put into a 500 mL four-necked flask equipped with a Dimroth condenser and a stirrer, and the mixture was stirred at 80°C for 4 hours. The mixture was cooled to room temperature and the component (E) was put thereinto and stirred for 1 hour at room temperature. The mixture was then filtered through a 100-mesh metal screen to prepare a varnish resin composition. Samples showing no varnish separation and remaining whole during this process were marked as ∘. Conversely, those with observed separation or undissolved residues were marked as ×. Further evaluation was not conducted for samples marked as ×."

### <Production of uncured resin film and handleability>

As for the examples where the resin varnishes were able to be produced unproblematically by the above process, a roller coater was used to apply the resin varnish to a PET film (TN-010 manufactured by TOYOBO STC CO,.LTD.) that had been subjected to a mold release treatment and had a thickness of 50 µm (TN-010 by TOYOBO STC CO, LTD), followed by drying the same at 100°C for 10 minutes to obtain an uncured resin film having a thickness of 50 µm. The handleability of the resultant uncured resin films was assessed by cutting the uncured resin films with a cutter knife. Films that exhibited no resin spillage from the uncured resin films were marked as o. Films that showed resin spillage from the uncured resin films were marked as Δ, while films that cracked during the production of the uncured resin films from the first place were marked as ×,

### <Relative permittivity, dielectric tangent>

The uncured resin film was directly fixed on a flat plate together with the PET film that had been subjected to a mold release treatment, followed by performing heating at 200°C for 60 min to cure the resin film so as to obtain a cured resin film. A network analyzer (E5063-2D5 by Keysight Technologies) and a stripline (by KEYCOM Corporation) were connected to measure a relative permittivity and a dielectric tangent of the cured resin film at a frequency of 10 GHz.

### <Glass-transition temperature>

A glass-transition temperature of the test sample (cured product) produced in a manner as set forth in "Relative permittivity, dielectric tangent" was calculated based on the measurement by DMA Q800 (by TA Instruments). The measurement was performed under a condition(s) of: a cured product of a size of 20 mm × 5 mm × thickness 50 µm; rate of temperature rise 5°C/min; multifrequency mode; tension mode; amplitude 15 µm.

### <Peeling strength>

There was prepared a SUS 304 plate having a length of 75 mm, a width of 25 mm and a thickness of 1.0 mm. An uncured resin film with the PET film was then placed on one surface of the SUS 304 plate so that the resin film surface thereof would come into contact with the one surface of the SUS 304 plate, followed by performing lamination at 100°C and 0.3 MPa for 60 seconds. After the lamination was over, the PET film was removed, and an 18 µm-thick copper foil (Ra: 0.17 µm) was then placed on and brought into contact with the resin film surface, followed by performing lamination at 100°C and 0.3 MPa for 60 seconds. After the lamination was over, an adhesion test piece was produced by heating the laminated product at 200°C for 60 min to cure it. In order to evaluate the adhesiveness, there was measured a 90° peeling adhesion strength (kN/m) when peeling the copper foil of each adhesion test piece from the SUS304 under the conditions at a temperature of 23°C and a tension rate of 50 mm/minute, in accordance with JIS-C-6481 "Test methods of copper-clad laminates for printed wiring boards. In addition, after leaving the adhesion test piece prepared by the above method at 130°C and 85% RH for 100 hours, there was again likewise measured the 90° peeling adhesion strength (kN/m) when peeling the copper foil of each adhesion test piece from the glass slide at the temperature of 23°C and the tension rate of 50 mm/min, in accordance with JIS-C-6481 "Test methods of copper-clad laminates for printed wiring boards."

### <Desmear resistance>

A glass epoxy substrate of double-sided copper foil (FR-4, trade name: R-1075 manufactured by Panasonic Industries Co., Ltd.) measuring 100 mm in length, 25 mm in width, and 1.0 mm in thickness was prepared, and the copper was reduced in a formic acid reflow furnace as a pretreatment. The uncured resin film with the PET film was then placed on one surface of the substrate so that the resin film surface thereof would come into contact with the one surface of the substrate, followed by performing lamination at 100°C and 0.3 MPa for 60 seconds. After the lamination was over, the PET film was removed, and it was heated at 200°C for 60 minutes to perform curing. The product was cut according to the adhesion test (Crosscut Test) as set forth in JIS K5600-5-6:1999. This substrate with the cured product was immersed in a swelling solution (Trade name: Swelling Dip manufactured by Atotech Japan K.K.) at 60°C for 10 minutes. Next, the substrate with the cured product was immersed in a swelling solution (Trade name: Swelling Dip manufactured by Atotech Japan K.K.) at 60°C for 10 minutes. Then, this substrate with the cured product was immersed in a roughening solution (Concentrate Compact P manufactured by Atotech Japan K.K.) at 80°C for 60 minutes. Finally, the substrate with the cured product was immersed in a neutralizing solution (Trade name: Reduction Conditioner Securiganth P manufactured by Atotech Japan K.K.) at 40°C for 5 minutes. The substrate was rinsed with water and then dried at 120°C for 20 minutes to visually confirm if peeling was observed. Samples showing no signs of peeling were marked as ∘, while those displaying peeling were marked as ×.

**Table 1**

| Composition table (parts by mass) | | | Working Examples | | | | | | | | | |
|---|---|---|---|---|---|---|---|---|---|---|---|---|
| | | | 1 | 2 | 3 | 4 | 5 | 6 | 7 | 8 | 9 | 10 |
| (A) | Aromatic bismaleimide | A-1 | 80.0 | | | 60.0 | 80.0 | 80.0 | 80.0 | 80.0 | 80.0 | 80.0 |
| | Aromatic bismaleimide | A-2 | | 80.0 | | | | | | | | |
| | Aromatic biscitraconimide | A-3 | | | 80.0 | | | | | | | |
| | BMI-5000 | A-4 | | | | | | | | | | |
| | Aliphatic biscitraconimide | A-5 | | | | | | | | | | |
| | BMI-1000 | A-6 | | | | | | | | | | |
| | BMI-4000 | A-7 | | | | | | | | | | |
| (B) | Aliphatic bismaleimide | B-1 | 20.0 | 20.0 | 20.0 | 40.0 | | | 20.0 | | 20.0 | 20.0 |
| | BMI-TMH | B-2 | | | | | 20.0 | | | | | |
| | Aliphatic biscitraconimide | B-3 | | | | | | 20.0 | | | | |
| (C) | jER-828 | C-1 | 5.0 | 5.0 | 5.0 | 5.0 | 5.0 | 5.0 | | 5.0 | 5.0 | 5.0 |
| | EPPN-501 | C-2 | | | | | | | 5.0 | | | |
| (D) | Amine curing agent | D-1 | 5.0 | 5.0 | 5.0 | 5.0 | 5.0 | 5.0 | 5.0 | | 5.0 | 5.0 |
| | TD-2131 | D-2 | | | | | | | | 5.0 | | |
| (E) | 2E4MZ | E-1 | 1.0 | 1.0 | 1.0 | 1.0 | 1.0 | 1.0 | 1.0 | 1.0 | | 1.0 |
| | TPP | E-2 | | | | | | | | | 2.0 | |
| | PERCUMYL D | E-3 | | | | | | | | | | |
| (F) | 5SV-CT1 Values in parenthesis ( ) indicate parts bv mass of solid | F-1 | 146.7 (110.0) | 146.7 (110.0) | 146.7 (110.0) | 146.7 (110.0) | 146.7 (110.0) | 146.7 (110.0) | 146.7 (110.0) | 146.7 (110.0) | 146.7 (110.0) | 333.3 (250.0) |
| (Solvent) | Anisole | | 240.0 | 240.0 | 240.0 | 180.0 | 240.0 | 240.0 | 240.0 | 240.0 | 240.0 | 240.0 |
| | Methyl ethyl ketone (MEK) | | | | | | | | | | | |
| Evaluation results | Compatibility | | ○ | ○ | ○ | ○ | ○ | ○ | ○ | ○ | ○ | ○ |
| | Handleability | | ○ | ○ | ○ | ○ | ○ | ○ | ○ | ○ | ○ | ○ |
| | Relative permittivity | | 3.0 | 3.0 | 3.0 | 2.9 | 3.0 | 2.9 | 3.0 | 3.0 | 3.0 | 3.2 |
| | Dielectric tangent | | 0.0031 | 0.0035 | 0.0028 | 0.0033 | 0.0030 | 0.0026 | 0.0029 | 0.0033 | 0.0035 | 0.0017 |
| | Glass-transition temperature | °C | 182 | 194 | 170 | 176 | 190 | 176 | 180 | 180 | 169 | 182 |
| | Peeling strength (Initial value) | kN/m | 1.0 | 1.0 | 1.2 | 1.2 | 1.1 | 1.3 | 0.9 | 0.9 | 1.1 | 0.8 |
| | Desmear resistance | | ○ | ○ | ○ | ○ | ○ | ○ | ○ | ○ | ○ | ○ |

**Table 2**

| Composition table (parts by mass) | | | Comparative Examples | | | | | | | | | |
|---|---|---|---|---|---|---|---|---|---|---|---|---|
| | | | 1 | 2 | 3 | 4 | 5 | 6 | 7 | 8 | 9 | 10 |
| (A) | Aromatic bismaleimide | A-1 | 100.0 | 100.0 | 80.0 | 80.0 | 80.0 | 50.0 | 80.0 | | | |
| | Aromatic bismaleimide | A-2 | | | | | | | | | | |
| | Aromatic biscitraconimide | A-3 | | | | | | | | | | |
| | BMI-5000 | A-4 | | | 20.0 | | | | | 80.0 | 80.0 | |
| | Aliphatic biscitraconimide | A-5 | | | | 20.0 | | | | | | 80.0 |
| | BMI-1000 | A-6 | | | | | 20.0 | 50.0 | | | | |
| | BMI-4000 | A-7 | | | | | | | 20.0 | | | |
| (B) | Aliphatic bismaleimide | B-1 | | | | | | | | 20.0 | 20.0 | 20.0 |
| | BMI-TMH | B-2 | | | | | | | | | | |
| | Aliphatic biscitraconimide | B-3 | | | | | | | | | | |
| (C) | jER-828 | C-1 | | | 5.0 | 5.0 | 5.0 | 5.0 | 5.0 | 5.0 | | 5.0 |
| | EPPN-501 | C-2 | | | | | | | | | | |
| (D) | Amine curing agent | D-1 | | | 5.0 | 5.0 | 5.0 | 5.0 | 5.0 | 5.0 | | 5.0 |
| | TD-2131 | D-2 | | | | | | | | | | |
| (E) | 2E4MZ | E-1 | | | 1.0 | 1.0 | 1.0 | 1.0 | 1.0 | 1.0 | | 1.0 |
| | TPP | E-2 | | | | | | | | | | |
| | PERCUMYL D | E-3 | 2.0 | 2.0 | | | | | | | 1.0 | |
| (F) | 5SV-CT1 Values in parenthesis () indicate parts bv mass of solid | F-1 | | 146.7 (110.0) | 146.7 (110.0) | 146.7 (110.0) | 146.7 (110.0) | 146.7 (110.0) | 146.7 (110.0) | 146.7 (110.0) | 146.7 (110.0) | 146.7 (110.0) |
| (Solvent) | Anisole | | 300.0 | 300.0 | 240.0 | 240.0 | 240.0 | 240.0 | 240.0 | 100.0 | 100.0 | 100.0 |
| | Methyl ethyl ketone (MEK) | | | | | | | 100.0 | | | | |
| Evaluation results | Compatibility | | ○ | ○ | × | × | ○ | ○ | ○ | ○ | ○ | ○ |
| | Handleability | | ○ | ○ | Not used for evaluation | Not used for evaluation | △ | × | △ | ○ | ○ | ○ |
| | Relative permittivity | | 2.8 | 3.0 | | | 3.2 | 3.3 | 3,2 | 2.9 | 2.9 | 2.9 |
| | Dielectric tangent | | 0.0060 | 0.0045 | | | 0.0081 | 0.012 | 0.0010 | 0.0029 | 0.0019 | 0.0026 |
| | Glass-transition temperature | °C | 195 | 194 | | | 196 | >200 | 200 | 48 | 62 | 36 |
| | Peeling strength (Initial value) | kN/m | 0.3 | 0.2 | | | 0.3 | <0.2 | 0.3 | 1.2 | 0.6 | 1.3 |
| | Desmear resistance | | ○ | ○ | | | ○ | × | ○ | × | × | × |

**Table 3**

| Composition table (parts by mass) | | | Comparative Examples | | | | | | | | | |
|---|---|---|---|---|---|---|---|---|---|---|---|---|
| | | | 11 | 12 | 13 | 14 | 15 | 16 | 17 | 18 | 19 | 20 |
| (A) | Aromatic bismaleimide | A-1 | | | | | 80.0 | 80.0 | 80.0 | | | |
| | Aromatic bismaleimide | A-2 | | | | | | | | | | |
| | Aromatic biscitraconimide | A-3 | | | | | | | | | | |
| | BMI-5000 | A-4 | | | | | | | | | | 50.0 |
| | Aliphatic biscitraconimide | A-5 | | | | | | | | | | |
| | BMI-1000 | A-6 | 100.0 | 100.0 | | | | | | | | 50.0 |
| | BMI-4000 | A-7 | | | | | | | | | | |
| (B) | Aliphatic bismaleimide | B-1 | | | | | 20.0 | 20.0 | 20.0 | | | |
| | BMI-TMH | B-2 | | | 100.0 | | | | | | | |
| | Aliphatic biscitraconimide | B-3 | | | | 100.0 | | | | | | |
| (C) | jER-828 | C-1 | | 5.0 | 5.0 | 5.0 | 5.0 | 5.0 | | | | 5.0 |
| | EPPN-501 | C-2 | | | | | | | | 72.8 | 62.0 | |
| (D) | Amine curing agent | D-1 | | 5.0 | 5.0 | 5.0 | | 5.0 | 5.0 | 27.2 | | 5.0 |
| | TD-2131 | D-2 | | | | | | | | | 38.0 | |
| (E) | 2E4MZ | E-1 | | 1.0 | 1.0 | 1.0 | 1.0 | 1.0 | | | | 1.0 |
| | TPP | E-2 | | | | | | | 2.0 | 2.0 | 2.0 | |
| | PERCUMYL D | E-3 | 1.0 | | | | | | | | | |
| (F) | 5SV-CT1 Values in parenthesis () indicate parts by mass of solid | F-1 | 146.7 (110.0) | 146.7 (110.0) | 146.7 (110.0) | 146.7 (110.0) | 146.7 (110.0) | | 146.7 (110.0) | 146.7 (110.0) | 146.7 (110.0) | 146.7 (110.0) |
| (Solvent) | Anisole | | | | 200.0 | 200.0 | 240.0 | 240.0 | 240.0 | 70.0 | 70.0 | 50.0 |
| | Methyl ethyl ketone (MEK) | | 300.0 | 300.0 | | | | | | 30.0 | 30.0 | 50.0 |
| Evaluation results | Compatibility | | ○ | ○ | ○ | ○ | ○ | ○ | ○ | ○ | ○ | × |
| | Handleability | | × | × | △ | No film was formed | ○ | ○ | △ | △ | △ | Not used for evaluation |
| | Relative permittivity | | 3.3 | 3.4 | 2.9 | | 3.0 | 2.8 | 2.8 | 3.6 | 3.5 | |
| | Dielectric tangent | | 0.013 | 0.019 | 0.0056 | | 0.0052 | 0.0062 | 0.0042 | 0.021 | 0.022 | |
| | Glass-transition temperature | °C | >200 | >200 | 190 | | 169 | 180 | 129 | 160 | 167 | |
| | Peeling strength (Initial value) | kN/m | <0.2 | <0.2 | 1.1 | | 1.2 | 1.0 | 0.4 | 0.3 | 0.3 | |
| | Desmear resistance | | × | × | × | | × | × | × | × | × | |

## Claims

1. A heat-curable resin composition comprising the components (A) to (F) of:
(A) an aromatic cyclic imide compound having a weight average molecular weight of 5,000 to 100,000;
(B) an aliphatic cyclic imide compound having a weight average molecular weight of 100 to 2,000;
(C) an epoxy resin having two or more epoxy groups in one molecule;
(D) a curing agent for epoxy resin;
(E) a curing catalyst; and
(F) an inorganic filler,
wherein the heat-curable resin composition comprises the components (A) to (E) in a total amount of 5 to 99% by mass based on the overall composition.

2. The heat-curable resin composition according to claim 1, wherein the aromatic cyclic imide compound (A) comprises at least one selected from aromatic cyclic imides represented in the following by formulae (1) and (2) defined as 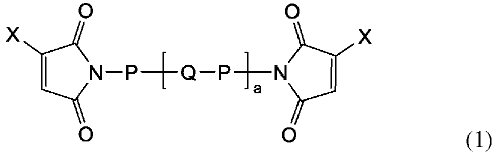
wherein, in the formula (1), P and Q are independently divalent groups represented by formulae defined as
**P:** 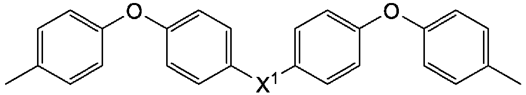
**Q**: 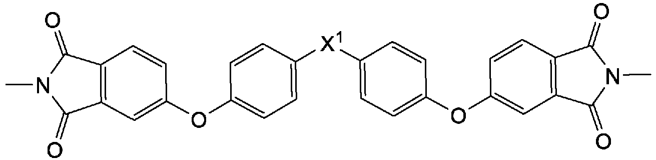 wherein each X¹ is independently a divalent group selected from formulae defined as 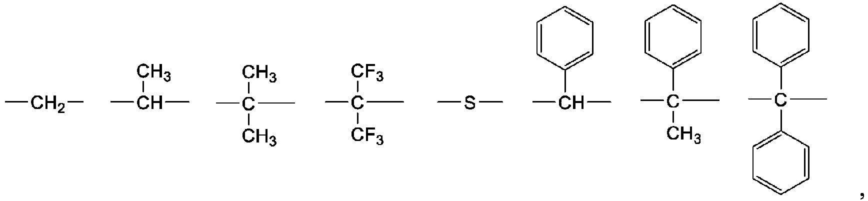 and
wherein, in the formula (1), a is a number of 1 to 40 and each X represents a hydrogen atom or a methyl group; and 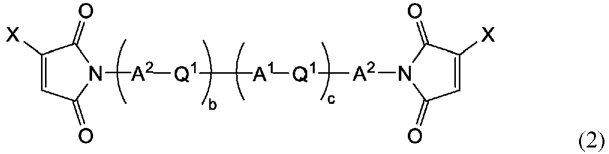
wherein, in the formula (2), each Q¹ independently is a divalent group represented by a formula defined as
**Q¹**: 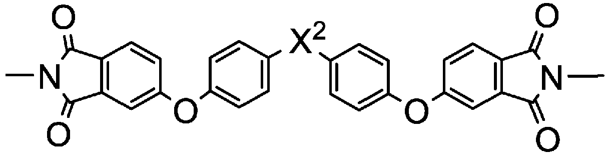 wherein each X² is independently a divalent group selected from formulae defined as 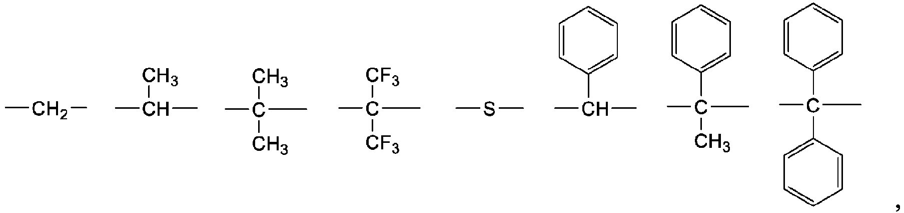 and
wherein, in the formula (2), b is a number of 1 to 50, c is a number of 1 to 50, each X represents a hydrogen atom or a methyl group and each of A¹ and A² independently represents a divalent group selected from formulae (3) and (4) defined as 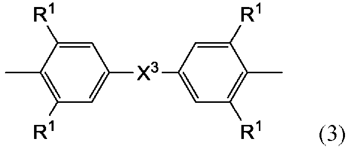 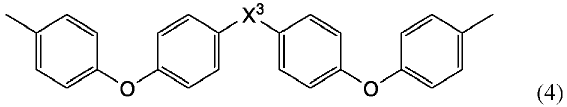
wherein, in the formulae (3) and (4), each X³ is a divalent group selected from formula defined as 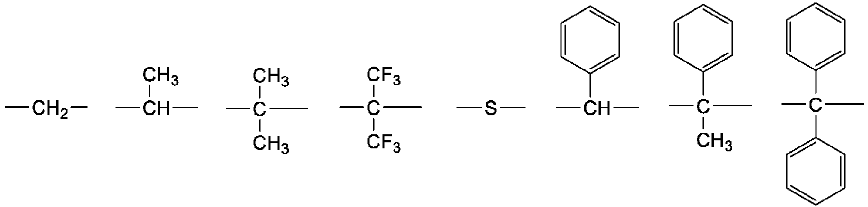
wherein, in the formula (3), each R¹ independently represents a hydrogen atom, a chlorine atom, or an aliphatic hydrocarbon group having 1 to 6 carbon atoms.

3. The heat-curable resin composition according to claim 1, wherein the aliphatic cyclic imide compound (B) is an aliphatic cyclic imide compound represented by a formula (5) defined as 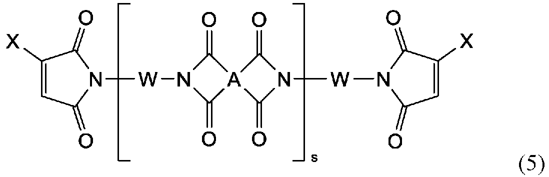 wherein, in the formula (5), each A independently represents a tetravalent organic group having an aliphatic cyclic structure, each X represents a hydrogen atom or a methyl group, each W independently represents a divalent aliphatic hydrocarbon group, having 5 to 25 caron atoms, which optionally contains a heteroatom, and s is 0 to 10.

4. The heat-curable resin composition according to claim 3, wherein W in the formula (5) is a linear or branched alkylene group having 5 to 25 carbon atoms or a divalent aliphatic hydrocarbon group represented by any one of the structures defined as 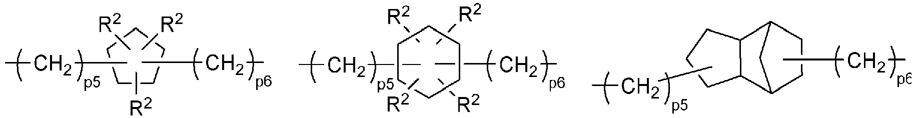 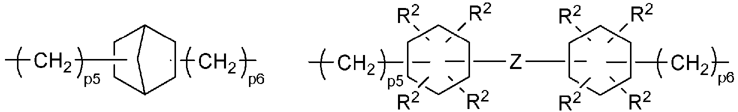 wherein p⁵ and p⁶ are each a number of 0 to 4 and may be identical to or different from each other, each R² independently represents a hydrogen atom or a linear or branched alkyl group having 1 to 20 carbon atoms, Z is an oxygen atom, a sulfur atom, or a methylene group, and wherein bonds in the above formulae that are yet unbonded to substituent groups are to be bonded to nitrogen atoms forming cyclic imide structures in the formula (5).

5. The heat-curable resin composition according to claim 1, wherein the aliphatic cyclic imide compound (B) is contained therein in an amount of 5 to 150 parts by mass based on 100 parts by mass of the aromatic cyclic imide compound (A).

6. The heat-curable resin composition according to claim 1, wherein the curing agent (D) for epoxy resin is an amine curing agent.

7. A bonding film comprising the heat-curable resin composition according to claim 1.

8. A prepreg comprising a cured product of the heat-curable resin composition according to claim 1.

9. A resin-clad copper foil comprising a cured product of the heat-curable resin composition according to claim 1.

10. A build-up film comprising the heat-curable resin composition according to claim 1.

11. A printed-wiring board comprising any one of: the prepreg according to claim 8; the resin-clad copper foil according to claim 9; and the build-up film according to claim 10.
